# EUROPEAN PATENT SPECIFICATION

(11) **EP 2 373 983 B1**
(45) Date of publication and mention of the grant of the patent: **26.07.2017**
(21) Application number: 09801782.5
(22) Date of filing: 09.12.2009
(51) Int. Cl.: G01N 27/20

(54) **ELECTRICAL WARNING SYSTEM FOR A ROBOTIC ARM**
ELEKTRISCHES WARNSYSTEM FÜR EINEN ROBOTERARM
SYSTÈME D'ALERTE ÉLECTRIQUE POUR BRAS ROBOTISÉ

(30) Priority: 25.12.2008 TR 200809839
(43) Date of publication of application: 12.10.2011
(73) Proprietor: Tofas Turk Otomobil Fabrikasi Anonim Sirketi, 16369 Bursa (TR)
(72) Inventor: YILDIZ, Ayhan, 16369 Bursa (TR)
(74) Representative: Dericioglu, E. Korhan
(86) International application number: PCT/IB2009/055587
(87) International publication number: WO 2010/073167

(56) References cited:
- WO-A1-2008/115664
- JP-A- 10 310 242
- JP-A- 60 131 449
- US-A- 5 969 260

## Description

### Field of the Invention

The present invention relates to a warning system which gives a warning in the event that there is cracking, breaking in workpiece carrier robot arms.

### Background of the Invention

The Japan patent document no. JP10310242, an application known in the art, discloses a system which controls the malfunctions in the carrier robot arm. The robot arm is used to carry vacuum air and wafers. Vacuum leakage or deficiency is detected by means of the groove present in the center of the robot arm and the system is stopped immediately.

The Japanese patent document no. JP62028654, another state of the art application, discloses a system which can control the cracks in the bar-shaped members electrically. The system can show the direction and the size of the crack as well. The system operates by disposing the electrical probes sequentially and connecting to a micro-potentiometer.

In the technique, invisible breaks or cracks are formed in the carrier robot arms. Serious damages occur in the robots due to these breaks or cracks and the robot arms toolings are broken. Although there are systems activating the safety system in the applications known in the art, the system can not sense the small deformations and the problem can not be noticed without air leakage

Documents JP60131449, US 5,969,260 and WO2008/115664 disclose methods of detecting defects in structures by disposing metallic wires on their surface and detecting the breakage of the wire by electrical methods.

### Summary of the Invention

The objective of the present invention is to realize a warning system which ensures that damages that may occur in dies are eliminated completely.

Another objective of the present invention is to realize a warning system which ensures elimination of mechanical problems which may occur in presses.

Yet another objective of the present invention is to realize a warning system which eliminates problems that may occur in the robot's own axis.

A further objective of the invention is to realize a warning system which provides robot arms that can be implemented easily in case of damage at low cost and can operate stably and permanently.

### Detailed Description of the Invention

A warning system realized to fulfill the objective of the present invention is illustrated in the accompanying figure, in which:

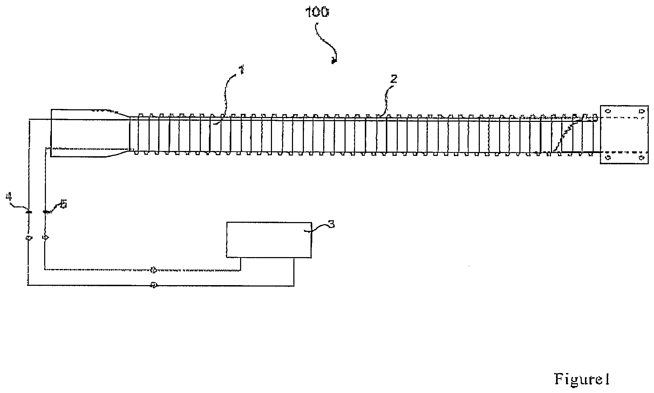

Figure 1 is the view of the damaged robot arm.

The parts illustrated in the figure are individually numbered where the numbers refer to the following:
- 100.: Warning system
- 1.: Robot arm
- 2.: Wire
- 3.: PLC unit
- 4.: Voltage input line
- 5.: Voltage output line

The inventive warning system (100) essentially comprises:
- at least one robot arm (1) which provides press feeding,
- at least one inelastic brittle wire (2) which is wound on the robot arm (1),
- at least one programmable logic controller (PLC) (3) which ensures that the movements in the control units are stopped by giving a fault signal,
- at least one voltage input line (4) which processes the signal data given to the wire (2),
- at least one voltage output line (5) which processes the signal data returned from the wire (2),

In the inventive warning system (100); the whole surface of the robot arm is made conductive by winding a wire (2) in the form of a coil like in wired potentiometer, around the robot arm (1).

In the inventive warning system (100), in case that an invisible break or crack is formed in the carrier robot arms (1) because of impact; conductivity of the surface is eliminated, no electric current passes over the wire (2) which is damaged following being affected by the breaks or cracks and this causes the circuit not to be completed. As a result of this, the fact that the signal data given to the wire (2) via the voltage input line (4) can not receive data in the voltage output line (5) indicates that the wire (2) is damaged and the system switches to the safe stop automatically. The PLC unit (3) which can not receive signal ensures that all movements are stopped by giving a fault signal to all control units. With the robot and the press stopping operating, an error code is shown in both robot and press displays by means of the warning system (100). By this means, it is ensured that damages that may occur in dies, mechanical problems which may occur in presses and problems that may occur in the robot's own axis are eliminated. In addition, robot arms (1) are provided which can intervene easily in case of damage at low cost and can operate stably and permanently.

## Claims

1. A warning system (100) **comprising**
- at least one robot arm (1) which provides press feeding,
- at least one programmable logic controller (PLC) (3) which ensures that movements are stopped by giving a fault signal to control units,
- at least one voltage input line (4) which processes the signal data,
- at least one voltage output line (5) which processes the returned signal data
**and characterized by** at least one inelastic brittle wire (2) which makes the whole surface of the robot arm (1) conductive by a winding on the robot arm (1) in the form of a coil,
wherein the PLC (3) is connected to the ends of the wire via at least one voltage input line (4) and at least one voltage output line (5) respectively.

2. A warning system (100) according to the preceding claim, wherein the system is adapted to:
- switch to the safe stop automatically because of the fact that the signal data given to the wire (2) by the PLC (3) via the voltage input line (4) can not receive data in the voltage output line (5), which indicates that the wire (2) is damaged,
- the PLC unit (3) which can not receive signal from the voltage output line (5) is adapted to ensure that all movements are stopped by giving a fault signal to all control units,
- an error code is being shown in both robot and press displays with the robot (1) and the press stops operating,
in case that an invisible break or crack is formed in the carrier robot arms (1) because of impact.

## Patentansprüche

1. Ein Warnsystem (100) **umfassend**
- mindestens einen Roboterarm (1), welcher Druckzuführung bereitstellt,
- mindestens eine speicherprogrammierbare Steuerung (SPS) (3), welche sicherstellt, dass die Bewegungen gestoppt werden, indem sie den Steuergeräten ein Fehlersignal gibt,
- mindestens eine Spannungseingangs-Leitung (4), welche die Signaldaten verarbeitet,
- mindestens eine Spannungsausgangs-Leitung (5), welche die zurückgekehrten Signaldaten verarbeitet
**und gekennzeichnet durch** mindestens einen unelastischen, spröden Draht (2), welcher die ganze Oberfläche des Roboterarms (1) durch eine Windung auf dem Roboterarm (1) in Form einer Spule leitfähig macht,
wobei die SPS (3) mit den Enden des Drahts jeweils über mindestens eine Spannungseingangs-Leitung (4) und mindestens eine Spannungsausgangs-Leitung (5) verbunden ist.

2. Ein Warnsystem (100) nach dem vorangehenden Anspruch, wobei,
das System angepasst ist,
- automatisch auf den sicheren Halt umzuschalten aufgrund der Tatsache, dass die durch die SPS (3) über die Spannungseingangs-Leitung (4) an den Draht (2) übermittelten Signaldaten keine Daten in der Spannungsausgangs-Leitung empfangen können (5), was wiederum anzeigt, dass der Draht (2) beschädigt ist,
- die SPS-Einheit (3), welche kein Signal aus der Spannungsausgangs-Leitung (5) empfangen kann, angepasst ist, um sicherzustellen, dass alle Bewegungen durch Angabe eines Fehlersignals an alle Steuereinheiten gestoppt sind,
- ein Fehlerkode sowohl in Roboter- als auch in der Pressenbildschirmen angezeigt wird, indem der Roboter (1) und die Presse den Betrieb stoppen, wenn infolge von Stößen ein unsichtbarer Bruch bzw. Riss in den Trägerroboterarmen (1) auftritt.

## Revendications

1. Système d'alerte (100) **comprenant**
- au moins un bras de robot (1) qui assure l'alimentation de la presse,
- au moins un contrôleur logique programmable (PLC) (3) qui assure que les mouvements sont arrêtés en donnant un signal de défaut aux unités de commande,
- au moins une ligne d'entrée de tension (4) qui traite les données de signal,
- au moins une ligne de sortie de tension (5) qui traite les données de signal renvoyées
**et caractérisé par** au moins un fil fragile inélastique (2) qui fait la surface totale du bras de robot (1) étant conductrice par un enroulement sur le bras de robot (1) sous la forme d'une bobine dans laquelle PLC (3) est relié aux extrémités du fil par l'intermédiaire d'au moins une ligne d'entrée de tension (4) et au moins une ligne de sortie de tension (5) respectivement.

2. Système d'alerte (100) selon la revendication précédente, dans lequel le système est adapté pour passer automatiquement à l'arrêt de sécurité en raison du fait que les données de signal fournies au fil (2) par PLC (3) par l'intermédiaire de la ligne d'entrée de tension (4) ne peut pas recevoir de données dans la ligne de sortie de tension (5), ce qui indique que le fil (2) est endommagé,
- l'unité de PLC (3) qui ne peut pas recevoir le signal de la ligne de sortie de tension (5) est adaptée pour assurer que tous les mouvements sont arrêtés en donnant un signal de défaut à toutes les unités de contrôle,
- un code d'erreur s'affiche à la fois sur le robot et l'écran de presse avec le robot (1) et la presse cesse de fonctionner, dans le cas où une rupture ou une fissure invisible est formée dans les bras du robot porteur (1) à cause de l'impact.
